# EUROPEAN PATENT SPECIFICATION

(11) **EP 3 522 689 B1**
(45) Date of publication and mention of the grant of the patent: **22.09.2021**
(21) Application number: 17855405.1
(22) Date of filing: 27.07.2017
(51) Int. Cl.: H05K 7/20, B32B 27/00, H01L 23/373, C09K 5/00, H01L 23/42

(54) **HEAT DISSIPATION SHEET HAVING HIGH LOAD CARRYING CAPACITY AND HIGH THERMAL CONDUCTIVITY**
WÄRMEABLEITENDE FOLIE MIT HOHER LASTTRAGFÄHIGKEIT UND HOHER WÄRMELEITFÄHIGKEIT
FEUILLE DE DISSIPATION DE CHALEUR AYANT UNE CAPACITÉ DE TRANSPORT DE CHARGE ÉLEVÉE ET UNE CONDUCTIVITÉ THERMIQUE ÉLEVÉE

(30) Priority: 30.09.2016 JP 2016194339
(43) Date of publication of application: 07.08.2019
(73) Proprietor: Denka Company Limited, Tokyo 103-8338 (JP)
(72) Inventor: WADA, Kosuke, Omuta-city Fukuoka 836-8510 (JP); YAMAGATA, Toshitaka, Omuta-city Fukuoka 836-8510 (JP); KANEKO, Masahide, Omuta-city Fukuoka 836-8510 (JP); MITSUNAGA, Toshikatsu, Omuta-city Fukuoka 836-8510 (JP)
(74) Representative: Gulde & Partner
(86) International application number: PCT/JP2017/027311
(87) International publication number: WO 2018/061447

(56) References cited:
- JP-A- H1 160 216
- JP-A- H06 155 517
- JP-A- 2000 085 024
- US-A- 5 705 258
- US-A- 6 054 520
- US-A- 6 074 963

## Description

### Technical Field

The present invention relates to a heat dissipation sheet (may be referred to as "thermally conductive sheet") to be brought into close contact with the interface between an electronic component and a heat dissipating portion such as a heat sink or a circuit board, for cooling a heat-generating electronic component.

### Background Art

A heat dissipation sheet is a sheet formed by coating a silicone composition generally containing a thermal conductive filling agent (hereinafter, referred to as a silicone composition) onto both surfaces of a reinforcing layer such as a glass cloth. Having excellent properties, such as a high thermal conductivity, electrical insulation property, and handling property, the sheet is used in close contact with the interface between an electronic component and a heat dissipating portion such as a heat sink or a circuit board for cooling a heat-generating electronic component in the electronic material field. For example, Patent Literatures 1 to 6 below each disclose a heat dissipation sheet having a thermal conducting layer provided on a reinforcing layer.

In accordance with rapid size reduction, higher integration, and higher output of electronic components in recent years, however, the operating temperature increases, and the heat dissipating capacity of conventional heat dissipation sheets becomes insufficient, causing operation failures to occur. Then, a higher thermal conductivity of heat dissipation sheets and a stronger adhesion between an electronic component and a heat dissipating portion are desired in order to improve the heat dissipating capacity.

Allowing a heat dissipation sheet to have a higher thermal conductivity according to the conventional art, however, requires use of a large amount of an expensive thermal conductive filler and use of an expensive metal foil as the reinforcing layer, thereby raising the cost, and thus, is not preferable. Meanwhile, strengthening the adhesion between an electronic component and a heat dissipating portion according to the conventional art can lower interfacial thermal resistance by increasing the load between the electronic component and the heat dissipating portion, thereby improving the heat dissipating capacity, but in a conventional heat dissipation sheet, a problem where an excessive load results in a break occurs. When such a break in the heat dissipation sheet occurs, an insulation failure or heat storage is brought about. This may lead to an operation failure of the electronic component and cause a major accident.

In increasing the load carrying capacity of the heat dissipation sheet according to the conventional art, thickening the glass cloth of the reinforcing layer or enlarging the fiber diameter of the glass cloth can make an improvement, but a decrease in the thermal conductivity lowers the heat dissipating capacity. Thus, this is not preferable either.

Additionally, although an attempt of enhancing the heat dissipating capacity by reducing the thickness of a heat dissipation sheet has been made, the load carrying capacity is inevitably impaired. Thus, this cannot solve the problem mentioned above.

In view of the above problems, a demand for a novel heat dissipation sheet that has an excellent load carrying capacity and thermal conductivity with low cost has been growing.

### Citation List

### Patent Literature

Patent Literature 1: Japanese Patent Laid-Open No. 8-336878
Patent Literature 2: Japanese Patent Laid-Open No. 9-001738
Patent Literature 3: Japanese Patent Laid-Open No. 11-307697
Patent Literature 4: Japanese Patent Laid-Open No. 7-266356
Patent Literature 5: Japanese Patent Laid-Open No. 9-199880
Patent Literature 6: JP 2000 - 085 024

### Summary of Invention

### Technical Problem

In view of the problems in the conventional art described above, it is an object of the present invention to provide a heat dissipation sheet that achieves both a high load carrying capacity and a high thermal conductivity at a low cost.

### Solution to Problem

The present inventors have intensively studied in order to solve the above problems and have found that a heat dissipation sheet excellent both in a high thermal conductivity and a high load carrying capacity can be obtained by employing a configuration with silicone composition layers containing a thermal conductive filler each layered on both surfaces of a reinforcing layer and optimizing the surface roughness and hardness of the surface on the side not bonded to the reinforcing layer in at least one of the silicone composition layers on both surfaces.

In one embodiment according to the present invention completed based on the above finding, it is possible to provide a heat dissipation sheet having a configuration with silicone composition layers containing a thermal conductive filler each layered on both surfaces of a reinforcing layer, wherein: in at least one of the silicone composition layers, the 10-point average roughness R_{zJIS} (10-point average roughness R_{zJIS} in compliance with Appendix JA of JIS B0601:2013) of the surface on the side not bonded to the reinforcing layer is in the range of 15 µm or more and 70 µm or less; the durometer A hardness of the silicone composition layers is in the range of 25 or more and 90 or less; and the thermal conductivity in the thickness direction of the heat dissipation sheet is 2.5 W/(m·K) or more.

In another embodiment of the heat dissipation sheet according to the present invention, the thermal conductive filler can comprise one or more materials selected from the group consisting of boron nitride, aluminum nitride, aluminum oxide, silicon nitride, silicon oxide, and zinc oxide. In a certain aspect of the embodiment, the boron nitride may be hexagonal boron nitride.

In still another embodiment of the heat dissipation sheet according to the present invention, the boron nitride may be in an aggregate form in which scaly primary particles of boron nitride are not oriented but aggregated.

In still another embodiment of the heat dissipation sheet according to the present invention, the silicone composition layers may contain the thermal conductive filler of 20 to 1,500 parts by mass with respect to a silicone component in a total amount of 100 parts by mass.

In still another embodiment of the heat dissipation sheet according to the present invention, the reinforcing layer may comprise one or more materials selected from the group consisting of a glass cloth, resin film, fabric mesh cloth, non-woven fabric, metallic fiber mesh cloth, and metal foil.

In still another embodiment of the heat dissipation sheet according to the present invention, the heat dissipation sheet may be a rolled heat dissipation sheet, and in still another embodiment, it is possible to provide a heat dissipation member obtained by using the heat dissipation sheet.

### Advantageous Effects of Invention

In accordance with the heat dissipation sheet according to the present invention, it is possible to achieve both a high load carrying capacity and a high thermal conductivity at a low cost. Additionally, such a heat dissipation sheet can also achieve an effect of capable of being prepared into a roll form that can be efficiently stamped.

### Brief Description of Drawings

[Figure 1] Figure 1 is an exemplary SEM micrograph of hexagonal boron nitride powder in an aggregate form.
[Figure 2] Figure 2 is a schematic view illustrating a method of using a heat dissipation sheet according to an embodiment of the present invention.
[Figure 3] Figure 3 is a schematic view illustrating a method of using a heat dissipation sheet according to an embodiment of the present invention.
[Figure 4] Figure 4 is a schematic view for describing an effect of the present invention.
[Figure 5] Figure 5 is a diagram for describing the shape of a specimen for measuring the volume resistivity of the heat dissipation sheet.

### Description of Embodiment

Hereinafter, the present invention will be described in further detail. In the present description, a numerical range includes both of the lower limit and the upper limit of a certain range, unless otherwise indicated.

The heat dissipation sheet according to the present invention has a reinforcing layer and layers of a silicone composition each layered on both surfaces of the reinforcing layer and having predetermined characteristics. Silicone, known to have properties as a preferable material in the electronic material field, is characterized by having all of a stable electrical insulation property over a broad temperature range, an excellent thermal conductivity, water resistance, and the like. The present inventors have found that further optimizing the surface roughness and hardness for a silicone composition obtained from such silicone achieves an excellent load carrying capacity and a thermal conductivity as a heat dissipation sheet and have arrived at the present invention.

### [Reinforcing layer]

The reinforcing layer that is used in the heat dissipation sheet according to the present invention serves to provide mechanical strength to the heat dissipation sheet and additionally achieves an effect of suppressing of elongation of the heat dissipation sheet in the plane direction. The material for the reinforcing layer may be optionally selected depending on applications of the heat dissipation sheet. In the case of a heat dissipation sheet in the electronic material field, for example, the sheet preferably include a glass cloth, resin film (such as polyester, polyamide, polyimide, polycarbonate, and acryl resin), fabric mesh cloth (such as cotton or hemp, aramid fiber, cellulose fiber, nylon fiber, and polyolefin fiber), non-woven fabric (such as aramid fiber, cellulose fiber, nylon fiber, and polyolefin fiber), metallic fiber mesh cloth (such as stainless steel, copper, and aluminum), or metal foil (such as copper foil, nickel foil, and aluminum foil). In particular, from the viewpoint of the thermal conductivity, it is further preferable to include a glass cloth or metal foil. From the viewpoint of the thermal conductivity and insulation property, it is further preferable to include a glass cloth. From the viewpoint of the insulation property, it is further preferable to include a resin film.

In the case where the reinforcing layer includes a metal foil or resin film, a metal foil or resin film having through holes is preferably used. In the electronic material field, it is preferable that each through hole size in the metal foil or resin film be 0.2 mm or more, each through-hole pitch interval be 0.7 mm or less, the opening ratio be 20 to 80%, and the thickness be 0.001 to 0.3 mm. Particularly, a resin film has a very high insulation property and has very few structural defects, thus achieving an excellent effect of a very highly reliable insulation property.

In the case where the reinforcing layer includes a glass cloth, a generally commercially available glass cloth having openings can be used. From the viewpoint of the thermal conductivity, the thickness of the glass cloth can be in the range of 10 µm to 150 µm, more preferably in the range of 20 to 150 µm, further preferably in the range of 30 to 100 µm, for example. The density of the glass cloth can be in the range of 5 to 100 threads/25 mm, more preferably in the range of 10 to 70 threads/25 mm, for example, from the viewpoint of the thermal conductivity. The tensile strength of the glass cloth can be in the range of 100 to 1000 N/25 mm, for example. The length of one side of an opening of the glass cloth can be in the range of 0.1 mm or more and 1.0 mm or less, for example, from the viewpoint of balancing the thermal conductivity with the strength.

Glass continuous fibers to be used in the glass cloth for use in a reinforcing material are preferably in a thread form obtained by drawing a glass base melted in a high temperature furnace at a high speed from a nozzle. Glass continuous fibers treated thermally or by a coupling agent are more preferable because theyhave a low content of impurities.

### [Silicone composition layer]

A silicone composition layer that is used in the heat dissipation sheet according to the present invention has both a 10-point average roughness R_{zJIS} and a durometer A hardness each in a predetermined range. Thus, the silicone composition layer is bonded to the reinforcing layer mentioned above, thereby enabling a marked heat dissipating capacity to be provided in cooperation with the reinforcing layer.

The silicone composition may be a silicone resin or silicone rubber. The type of a silicone component is not particularly limited, but peroxide-curable, condensation reaction-curable, addition reaction-curable, and ultraviolet curable type silicone components can be preferably used. Especially, silicone rubbers are believed to be preferable because being likely to exert the effects of the present invention due to their elasticity and hardness.

The 10-point average roughness R_{zJIS} (10-point average roughness R_{zJIS} in compliance with Appendix JA of JIS B0601:2013) of the open surface of the silicone composition (surface not bonded to the reinforcing layer) is preferably in the range of 15 µm or more and 70 µm or less, more preferably in the range of 20 µm or more and 65 µm or less. The case where R_{zJIS} is less than 15 µm is not preferable because the stress buffering effect of recess and projection portions of the surface is reduced to lower the load carrying capacity. The case where R_{zJIS} is more than 70 µm is not preferable because the thickness accuracy is lowered to cause slack when the heat dissipation sheet is formed into a roll. For example, after coating of the silicone composition, at the time of bonding and·vulcanizing (curing) by application of pressure or heat, the 10-point average roughness R_{zJIS} can be adjusted by appropriately setting the pressure and temperature (this will be described in detail below) . On measuring R_{zJIS}, a roughness curve is collected along a line connecting two points on the surface of the object to be measured. In this case, also when a pattern having anisotropy is provided on the surface, it is general to take any of the following countermeasures, for example, in order to prevent deviation in the measurements. That is, collection is conducted twice or more by changing the direction in which the roughness curve is collected, and the values obtained are sorted out (higher values are collected, or values are averaged); the direction in which the roughness curve is collected is set so as not to allow the curve to be along the pattern having anisotropy; and the distance between the recess and projection portions (RSm) of the pattern having anisotropy is specified, and R_{zJIS} is measured by removing values that do not satisfy the minimum height criteria, as noises, among heights and depths of the roughness curve. These countermeasures can be automatically conducted by a measurement instrument.

The durometer A hardness of the silicone composition is preferably in the range of 25 or more and 90 or less, more preferably in the range of 50 or more and 85 or less. The case where the durometer A hardness is less than 25 is not preferable because, when a heat dissipation sheet including the silicone composition layer is attempted to be processed into a roll, the sheet is broken and fails to be rolled. The case where the durometer A hardness is more than 90 is not preferable because, when the heat dissipation sheet is formed into a roll, the surface partially cracks. The durometer A hardness is measured by a method in compliance with JIS K6253. In the present description, in order to unify measuring methods, a type A durometer is used to obtain measurements for convenience, even in the case where the hardness is more than 90 and less than 20.

The method for coating the silicone composition is not particularly limited, and it is possible to employ a known coating method, such as a doctor blade method, comma coating method, screen printing method, and roll coater method, which enables uniform coating. In consideration of the thickness accuracy of the silicone composition, the doctor blade method and comma coating method are preferable.

The silicone composition contains a thermal conductive filler described below preferably in the range of 20 parts by mass or more and 1,500 parts by mass or less, more preferably in the range of 100 parts by mass or more and 1,300 parts by mass or less, further preferably in the range of 200 parts by mass or more 800 parts by mass or less, even more preferably in the range of 240 parts by mass or more and 730 parts by mass or less, with respect to the silicone component in a total amount of 100 parts by mass. When the content of the thermal conductive filler is less than 20 parts by mass, the thermal conductivity is lowered, and the heat dissipating capacity is lowered. In contrast, when the content of the thermal conductive filler is more than 1,500 parts by mass, silicone and the thermal conductive filler do not mix sufficiently, and the thickness may become inhomogeneous on coating the composition to the reinforcing layer such as a glass cloth having openings.

### [Thermal conductive filler]

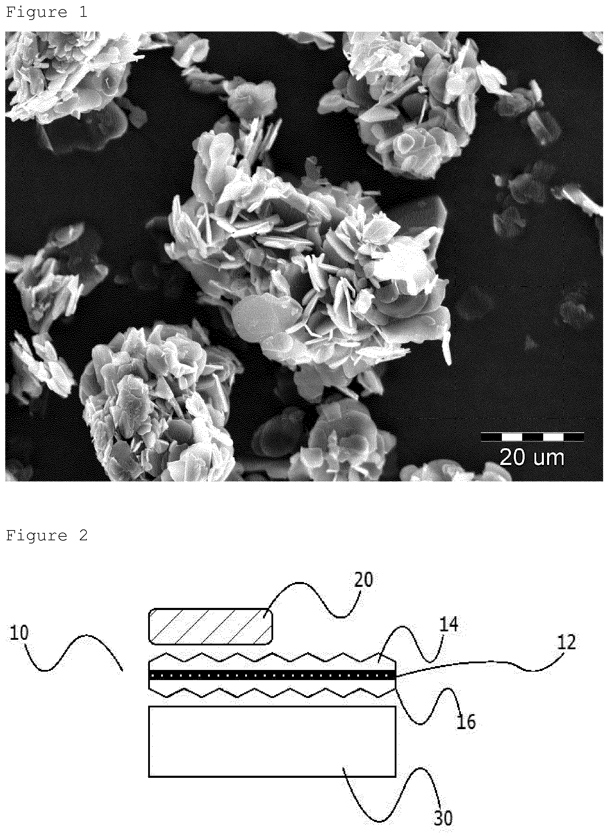

Examples of the thermal conductive filler that are added to the silicone composition layer include, but are not limited to, boron nitride powder, aluminum nitride powder, aluminum oxide powder, silicon nitride powder, silicon oxide powder, and zinc oxide powder. From the viewpoint of improving the thermal conductivity and processability, boron nitride powder or aluminum oxide powder is preferably used, boron nitride powder, especially hexagonal boron nitride powder is further preferably used. The form of hexagonal boron nitride is preferably an aggregate form, in which scaly primary particles of boron nitride are not oriented but aggregated, because an effect of imparting no anisotropy to the thermal conductivity can be obtained. A micrograph of hexagonal boron nitride powder in an aggregate form is exemplarily shown in Figure 1. With hexagonal boron nitride powder not in an aggregate form, there may be a case where the thermal conductivity is lowered and thus the heat dissipating capacity is lowered.

### [Heat dissipation sheet]

Figures 2 to 4 explain the reason why the heat dissipation sheet according to the embodiment of the present invention achieves the operation effect described above by having a predetermined surface roughness (10-point average roughness) on its surface (i.e., the open surface of the silicone composition layer) and having a predetermined hardness.

Figure 2 depicts an aspect in which a heat dissipation sheet 10 has a reinforcing layer 12, a front side silicone composition layer 14, and a back side silicone composition layer 16. The roughness on the surface each of the front side silicone composition layer 14 and the back side silicone composition layer 16 is exaggeratedly illustrated. The heat dissipation sheet 10 is placed on a heat dissipation member 30, and a heat-generating electronic component 20 is placed on the heat dissipation sheet 10 (intervals between components are exaggeratedly illustrated). With respect to the front side and back side of the heat dissipation sheet in the present description, the surface on the side to be in contact with the heat-generating electronic component (such as a transistor) is defined as "front", and the surface on the side to be in contact with the heat dissipation member (a heat sink, a substrate, or the like) is defined as "back". These definitions are only for convenience, and it should be understood that, when the heat dissipation sheet is present solely, the front and the back need not be determined definitely.

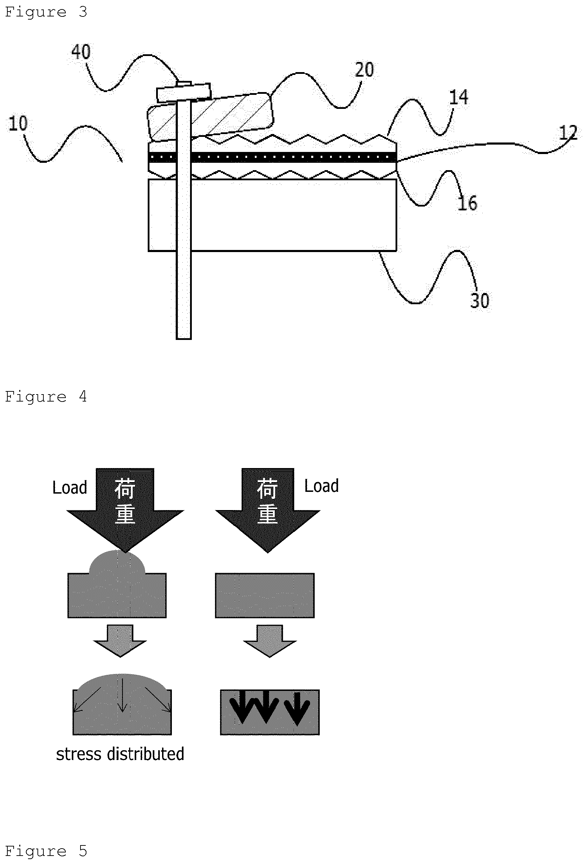

Figure 3 exaggeratedly depicts an aspect in which fixing the components shown in Figure 2 with a screw 40 results in a stress such that the electronic component 20 is inclined and the stress is placed locally on the heat dissipation sheet 10. The screw 40 may pass through the through hole of each component, not shown in Figure 2. When the screw 40 is tightened at a torque, the electronic component 20 is often inclined as described above. Use of a heat dissipation sheet according to the conventional art has a problem where the sheet cannot withstand this local stress concentration, thereby causing a break. In contrast, the heat dissipation sheet according to the present invention 10 achieves an effect that the sheet is unlikely to be broken because its rough surface buffers the stress. Although the following is a hypothesis, it is assumed that the sheet serves to buffer the locally-placed stress by a combination of projection portions of an appropriate size among the recesses and projections present on the rough surface of the silicone composition layer with the appropriate hardness possessed by the silicone composition layer. Figure 4 schematically depicts how this stress is distributed. It is believed that the sheet can more appropriately distribute the stress by deforming such that the projection portion to which the stress has been placed is moderately collapsed in comparison to a sheet having no projection portion.

The thickness of the heat dissipation sheet is not particularly limited, and is generally of the order of 0.05 to 1.2 mm. In consideration of reduction in the thermal resistivity, the thickness can be preferably 1.0 mm or less, more preferably 0.4 mm or less, further preferably 0.3 mm or less. The thickness per one silicone composition layer is not particularly limited in the range within which the function of the heat dissipation sheet can be obtained. The thickness can be, for example, of the order of 0.01 to 1.0 mm, preferably of the order of 0.05 to 0.5 mm.

To simplify the explanation, only the aspect in which the heat dissipation sheet has two silicone composition layers and one reinforcing layer has been described in the above description. Of course, it is also possible to provide an optional additional layer or to increase the number of layers as long as the function of the heat dissipation sheet is not impaired. For example, it is also possible to provide an additional layer (protective layer, release paper, or the like) on the open surface of the silicone composition layer. Alternatively, an aspect is also enabled in which a plurality of reinforcing layers is provided and an additional layer (adhesive layer or the like) is provided therebetween.

The above description has been provided as if the size of the surface of the reinforcing layer is equivalent to that of the silicone composition layer, for convenience, but this is also illustrative only. As long as the function of the heat dissipation sheet is not impaired, the size of the surface of the reinforcing layer may be different from that of the silicone composition layer, or the surface of each of two silicone composition layers may have a different size. Additionally, the thicknesses of two silicone composition layers may be the same or different. In a certain embodiment, there may be an aspect in which a plurality of silicone composition layers (divided into a plurality of layers by a surface perpendicular to the sheet surface) is provided on the reinforcing layer, or the silicone composition layers on both surfaces may be each divided in a different manner.

The following method does not form part of the presently claimed invention. In a method for manufacturing a heat dissipation sheet, a thermal conductive filler-containing silicone composition layer is bonded to a reinforcing layer, and recesses and projections are imparted at a predetermined surface roughness on its surface. After the silicone composition is coated onto both surfaces of a reinforcing layer (such as a glass cloth having openings), bonding under pressure is preferably conducted. The bonding is preferably conducted, for example, using an embossing roll press in an air atmosphere under a condition of a line pressure of 50 to 150 N/mm. When the pressure is less than 50 N/mm, a problem may be caused in that the bonding property between the thermal conductive filler-containing silicone composition and the reinforcing material having through holes is lowered. When the pressure is more than 150 N/mm, there may be a problem where the strength of the thermal conductive filler-containing silicone composition and the reinforcing layer having through holes is lowered. Thereafter, in order to remove alcohol, carboxylic acid, and low molecular weight siloxane by-produced by crosslinking reaction of the silicone composition, it is preferable to vulcanize the silicone composition by conducting secondary heating under conditions of 130 to 250°C and 5 to 30 hours. The surface geometry of the roll of the embossing roll press is not particularly limited, and is preferably a satin pattern, matte finish pattern, block check pattern, houndstooth check pattern, and the like.

### Examples

### (Example 1)

A polyorganosiloxane base polymer (manufactured by Dow Corning Toray Silicone Co., Ltd., trade name: "CF3110") of 100 parts by mass, a crosslinking agent (manufactured by Dow Corning Toray Silicone Co., Ltd., trade name: "RC-4") of 1 part by mass, and an aggregate-form boron nitride powder (Denka Company Limited, SGPS grade, hereinafter, abbreviated as "SGPS") in an amount (parts by mass) shown in Table 1 and Table 2 were introduced, dispersed in toluene of 500 parts by mass, and mixed by a stirrer for 15 hours to prepare a thermal conductive filler-containing silicone rubber composition.

The above silicone rubber composition was coated onto a glass cloth (manufactured by Unitika Ltd., trade name: "H47") as a reinforcing layer, shown in Table 1, with a comma coater in a thickness per surface of 0.175 mm and dried at 75°C for 5 minutes. Then, the composition was also coated onto the other surface of the glass cloth with a comma coater in a thickness of 0.175 mm to produce a laminate. Subsequently, pressing was conducted using an embossing roll press manufactured by YURI ROLL Co., Ltd. to produce a sheet having a thickness of 0.20 mm. Subsequently, the sheet was subjected to secondary heating at normal pressure and 150°C for 4 hours to provide a heat dissipation sheet. The resulting heat dissipation sheet was rolled up into the form of a roll of 1 m in width × 10 m.

### (Examples 2 to 14 and Comparative Examples 1 to 4)

Each heat dissipation sheet was produced in the same manner as in Example 1 except that the conditions shown in Tables 1 to 3 were used.

### (Evaluation)

The prototyped heat dissipation sheets of Examples 1 to 4 and Comparative Examples 1 to 4 were evaluated in accordance with the following evaluation items (1) to (5). The results are shown in Tables 1 to 3. Examples in which the heat dissipation sheet failed to be correctly rolled up in the form of a roll of 1 m in width × 10 m (due to slack or surface cracking) are indicated as "No" in "Producibility of roll form".

### (1) Volume resistivity

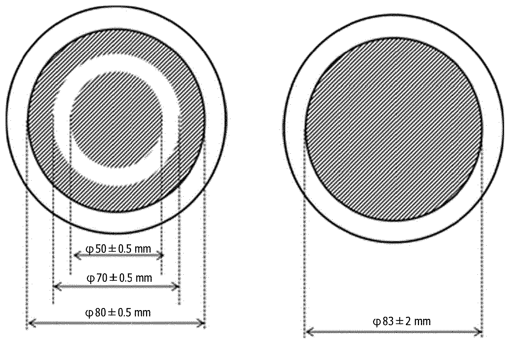

A specimen having a shape shown in Figure 5 was produced from the heat dissipation sheet. A silver paste was coated onto the areas shown as the shaded portions of Figure 5 of both surfaces of the specimen. Then, the volume resistivity was evaluated in compliance with the method described in JIS C2139:2008.

### (2) Thermal conductivity

The thermal conductivity (H; unit: W/(m·K)) was evaluated in the thickness direction of the heat dissipation sheet. The thermal conductivity was calculated from the thermal diffusivity (A; unit: m²/sec), density (B; unit: kg/m³), and specific heat capacity (C; unit: J/(kg·K)), as H = A × B × C. A measurement sample was processed to have a size of 10 mm in width × 10 mm in length, and in order to prevent reflection of the laser light for measurement, carbon black was coated onto both surfaces of the heat dissipation sheet. Then, the thermal diffusivity was determined by a laser flash method. The measurement instrument used was a xenon flash analyzer (manufactured by NETZSCH GmbH, trade name: "LFA447 NanoFlash"). The density was determined using the Archimedes method. The specific heat capacity was determined in compliance with the method described in JIS K7123:1987.

### (3) Evaluation of load carrying capacity

Five heat dissipation sheets of 40 mm × 40 mm were provided. The center of each heat dissipation sheet was stamped out with a die of φ5 mm in inner diameter, equipped with a Thomson blade, to provide a screw hole. Each heat dissipation sheet was sandwiched between a TO-3P form transistor (size of contact portion: 20 mm × 26 mm) and an aluminum plate of 1 mm in thickness so as to align the positions of the screw holes. An M3P0.5 form screw passing through the screw holes and a torque driver were used to tighten the sandwiched sheet for an hour by applying a torque so as to achieve the load (surface pressure) shown in Tables 1 to 3 below. Thereafter, the screw was removed, and the sheet was visually checked for a break. In the case where it is difficult to visually check the sheet for a break, electrodes are brought into contact with both surfaces of the sheet with the screw removed while the peripheral portion of the screw hole is avoided. Then, a voltage of 1.0 kV DC is applied to the sheet. The sheet was evaluated to have a break when energized or to have no break when not energized.

### (4) 10-Point average roughness R_{zJIS}

The 10-point average roughness R_{zJIS} of the surface of the silicone rubber composition layers was evaluated using a confocal microscope (manufactured by KEYENCE CORPORATION, trade name: "LT·9010M") under conditions of measurement length: 10,000 µm, measurement pitch: 10 µm, and measurement rate: 500 µm in compliance with JIS B0601:2013.

### (5) Durometer A hardness

For the durometer A hardness of the silicone rubber composition layer, specimens were prepared from the same materials under the same conditions as for the silicone composition layer used in each of Examples and Comparative Examples and subjected to measurement by a method in compliance with JIS K6249:2003. The temperature of the specimens during the measurement was controlled also in accordance with the specification of the JIS. With respect to the durometer A hardness of the silicone rubber composition layer, in the case of such a configuration as used in the present Examples, even laminating heat dissipation sheets so as to reach a specified thickness and performing a measurement can obtain an approximate value.

**[Table 1]**

| | | Unit | Example 1 | Example 2 | Example 3 | Example 4 | Example 5 | Example 6 | Example 7 |
|---|---|---|---|---|---|---|---|---|---|
| Glass cloth | Density | Threads/25 mm | 50 | 50 | 50 | 50 | 50 | 50 | 50 |
| | Thickness | mm | 0.06 | 0.06 | 0.06 | 0.06 | 0.06 | 0.06 | 0.06 |
| | Tensile strength | N/25mm | 500 | 500 | 500 | 500 | 500 | 500 | 500 |
| Silicone | Amount added | Parts by mass | 100 | 100 | 100 | 100 | 100 | 100 | 100 |
| Thermal conductive filler | Type | - | SGPS | SGPS | SGPS | SGPS | SGPS | SGPS | SGPS |
| | Amount added | Parts by mass | 350 | 350 | 350 | 350 | 350 | 350 | 350 |
| Sheet surface roughness RzJIS | Front | µm | 45 | 65 | 23 | 45 | 21 | 44 | 65 |
| | Back | µm | 20 | 20 | 20 | 46 | 20 | 66 | 63 |
| Load carrying capacity test Number of breaks occurred | Load 0.5 MPa | - | 0/5 | 0/5 | 0/5 | 0/5 | 0/5 | 0/5 | 0/5 |
| | Load 1.0 MPa | - | 0/5 | 0/5 | 0/5 | 0/5 | 0/5 | 0/5 | 0/5 |
| | Load 3.0 MPa | - | 0/5 | 0/5 | 0/5 | 0/5 | 0/5 | 0/5 | 0/5 |
| | Load 5.0 MPa | - | 0/5 | 0/5 | 0/5 | 0/5 | 0/5 | 0/5 | 0/5 |
| | Load 7.0 MPa | - | 0/5 | 0/5 | 0/5 | 0/5 | 0/5 | 0/5 | 0/5 |
| Sheet hardness | | Durometer A | 75 | 75 | 75 | 75 | 75 | 75 | 75 |
| Producibility of roll form | | - | Yes | Yes | Yes | Yes | Yes | Yes | Yes |
| Size | Length | m | 10 | 10 | 10 | 10 | 10 | 10 | 10 |
| | Width | m | 1 | 1 | 1 | 1 | 1 | 1 | 1 |
| | Total thickness | mm | 0.2 | 0.2 | 0.2 | 0.2 | 0.2 | 0.2 | 0.2 |
| Volume resistivity | | Ω·cm | 5.3×10¹⁴ | 5.2×10¹⁴ | 5.5×10¹⁴ | 5.2×10¹⁴ | 5.3×10¹⁴ | 5.3×10¹⁴ | 5.5×10¹⁴ |
| Thermal conductivity | | W/(m·K) | 5 | 5 | 5 | 5 | 5 | 5 | 5 |

**[Table 2]**

| | | Unit | Example 8 | Example 9 | Example 10 | Example 11 | Example 12 | Example 13 | Example 14 |
|---|---|---|---|---|---|---|---|---|---|
| Glass cloth | Density | Threads/25 mm | 50 | 50 | 50 | 50 | 50 | 50 | 50 |
| | Thickness | mm | 0.06 | 0.06 | 0.06 | 0.06 | 0.06 | 0.06 | 0.06 |
| | Tensile strength | N/25mm | 500 | 500 | 500 | 500 | 500 | 500 | 500 |
| Silicone | Amount added | Parts by mass | 100 | 100 | 100 | 100 | 100 | 100 | 100 |
| Thermal conductive filler | Type | - | SGPS | SGPS | SGPS | SGPS | SGPS | SGPS | Al2O3 |
| | Amount added | Parts by mass | 350 | 350 | 240 | 730 | 100 | 1300 | 1300 |
| Sheet surface roughness RzJIS | Front | µm | 10 | 11 | 45 | 45 | 45 | 45 | 45 |
| | Back | µm | 65 | 20 | 20 | 20 | 20 | 20 | 20 |
| Load carrying capacity test Number of breaks occurred | Load 0.5 MPa | - | 0/5 | 0/5 | 0/5 | 0/5 | 0/5 | 0/5 | 0/5 |
| | Load 1.0 MPa | - | 0/5 | 0/5 | 0/5 | 0/5 | 0/5 | 0/5 | 0/5 |
| | Load 3.0 MPa | - | 0/5 | 0/5 | 0/5 | 0/5 | 0/5 | 0/5 | 0/5 |
| | Load 5.0 MPa | - | 0/5 | 0/5 | 0/5 | 0/5 | 0/5 | 0/5 | 0/5 |
| | Load 7.0 MPa | - | 0/5 | 0/5 | 0/5 | 0/5 | 0/5 | 0/5 | 0/5 |
| Sheet hardness | | Durometer A | 75 | 75 | 70 | 81 | 56 | 85 | 85 |
| Producibility of roll form | | - | Yes | Yes | Yes | Yes | Yes | Yes | Yes |
| Size | Length | m | 10 | 10 | 10 | 10 | 10 | 10 | 10 |
| | Width | m | 1 | 1 | 1 | 1 | 1 | 1 | 1 |
| | Total thickness | mm | 0.2 | 0.2 | 0.2 | 0.2 | 0.2 | 0.2 | 0.2 |
| Volume resistivity | | Ω.cm | 5.5×10¹⁴ | 5.5×10¹⁴ | 5.3×10¹⁴ | 5.6×10¹⁴ | 5.5×10¹⁴ | 5.4×10¹⁴ | 5.3×10¹⁴ |
| Thermal conductivity | | W/(m·K) | 5 | 5 | 4 | 5 | 4 | 5 | 4 |

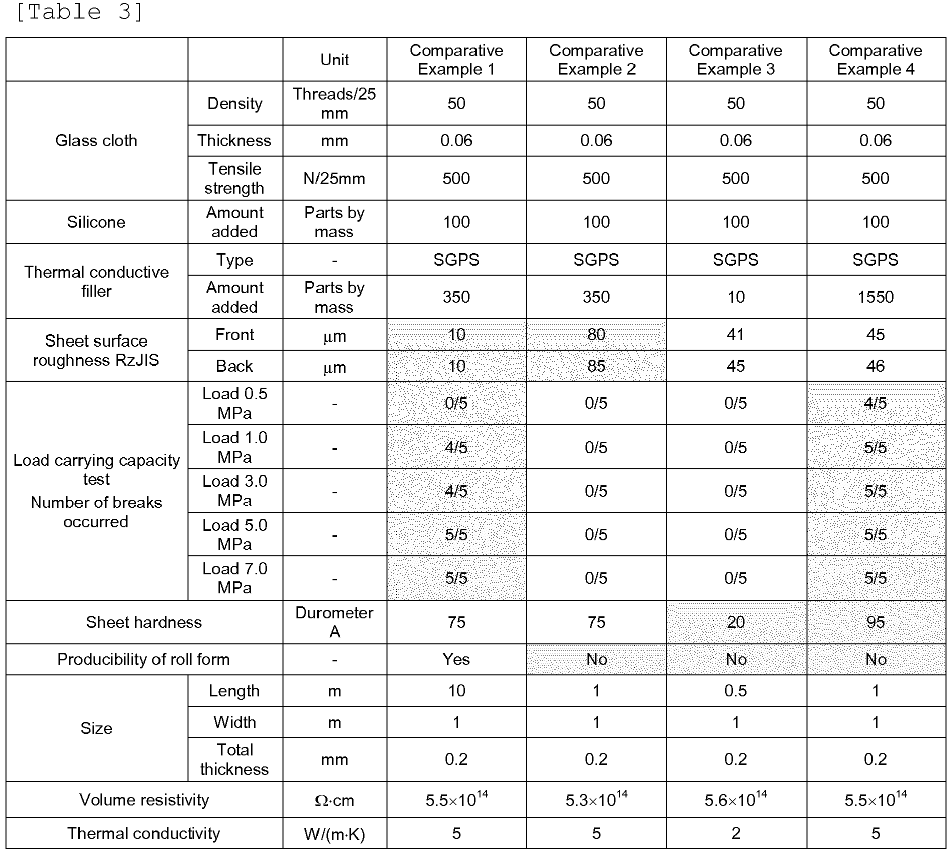

From Examples in Tables 1 to 2 and Comparative Examples in Table 3, it can be seen that the rolled heat dissipation sheets according to Examples of the present invention exhibit an excellent load carrying capacity and a high thermal conductivity, that is, can exhibit a high heat dissipating capacity.

### Industrial Applicability

The heat dissipation sheet of the present invention, which has a high heat dissipating capacity and an excellent electrical insulation property, can be used for a thermal interface material (TIM) and the like that allow electronic components, which have been rapidly sophisticated, thereby raising their operation temperature, to efficiently release heat.

### Reference Signs List

- 10: heat dissipation sheet
- 12: reinforcing layer
- 14: front side silicone composition layer
- 16: back side silicone composition layer
- 20: heat-generating electronic component
- 30: heat dissipation member
- 40: screw

## Claims

1. A heat dissipation sheet (10) having a configuration with silicone composition layers (14, 16) containing a thermal conductive filler each layered on both surfaces of a reinforcing layer (12), wherein a durometer A hardness of the silicone composition layers is in the range of 25 or more and 90 or less; and
a thermal conductivity in a thickness direction of the heat dissipation sheet is 2.5 W/(m·K) or more, **characterised in that**:
in at least one of the silicone composition layers present on both surfaces of the heat dissipation sheet, a 10-point average roughness R_{zJIS} of the surface on the side not bonded to the reinforcing layer is in the range of 15 µm or more and 70 µm or less.

2. The heat dissipation sheet according to claim 1, wherein the thermal conductive filler comprises one or more materials selected from the group consisting of boron nitride, aluminum nitride, aluminum oxide, silicon nitride, silicon oxide, and zinc oxide.

3. The heat dissipation sheet according to claim 2, wherein the boron nitride is hexagonal boron nitride.

4. The heat dissipation sheet according to claim 3, wherein the boron nitride is in an aggregate form in which scaly primary particles of boron nitride are not oriented but aggregated.

5. The heat dissipation sheet according to any one of claims 1 to 4, wherein the silicone composition layers (14, 16) contain the thermal conductive filler in the range of 20 parts by mass or more and 1,500 parts by mass or less with respect to a silicone component in a total amount of 100 parts by mass.

6. The heat dissipation sheet according to any one of claims 1 to 5, wherein the reinforcing layer (12) comprises one or more materials selected from the group consisting of a glass cloth, resin film, fabric mesh cloth, non-woven fabric, metallic fiber mesh cloth, and metal foil.

7. The heat dissipation sheet according to any one of claims 1 to 6, wherein the heat dissipation sheet (10) is a rolled heat dissipation sheet.

8. A heat dissipation member (30) obtained by using the heat dissipation sheet according to any one of claims 1 to 7.

## Patentansprüche

1. Wärmeableitende Folie (10), die eine Konfiguration mit Silikonzusammensetzungsschichten (14, 16) aufweist, die einen wärmeleitenden Füllstoff enthalten und jeweils auf beiden Oberflächen einer Verstärkungsschicht (12) geschichtet angeordnet sind, wobei eine Durometer A-Härte der Silikonzusammensetzungsschichten im Bereich von 25 oder mehr und 90 oder weniger liegt; und
eine Wärmeleitfähigkeit in einer Dickenrichtung der wärmeableitenden Folie 2,5 W/(m·K) oder mehr beträgt, **dadurch gekennzeichnet, dass**:
in mindestens einer der Silikonzusammensetzungsschichten, die auf beiden Oberflächen der wärmeableitenden Folie vorhanden sind, eine 10-Punkte-Durchschnittsrauhigkeit R_{zJIS} der Oberfläche auf der Seite, welche nicht mit der Verstärkungsschicht verbunden ist, im Bereich von 15 µm oder mehr und 70 µm oder weniger liegt.

2. Wärmeableitende Folie nach Anspruch 1, wobei der wärmeleitende Füllstoff ein oder mehrere Materialien umfasst, die aus der Gruppe ausgewählt sind, die aus Bornitrid, Aluminiumnitrid, Aluminiumoxid, Siliziumnitrid, Siliziumoxid und Zinkoxid besteht.

3. Wärmeableitende Folie nach Anspruch 2, wobei es sich bei dem Bornitrid um hexagonales Bornitrid handelt.

4. Wärmeableitende Folie nach Anspruch 3, wobei das Bornitrid in einer Aggregatform vorliegt, in der schuppige Primärteilchen aus Bornitrid nicht orientiert, sondern aggregiert sind.

5. Wärmeableitende Folie nach einem der Ansprüche 1 bis 4, wobei die Silikonzusammensetzungsschichten (14, 16) den wärmeleitenden Füllstoff im Bereich von 20 Masseteilen oder mehr und 1.500 Masseteilen oder weniger in Bezug auf eine Silikonkomponente in einer Gesamtmenge von 100 Masseteilen enthalten.

6. Wärmeableitende Folie nach einem der Ansprüche 1 bis 5, wobei die Verstärkungsschicht (12) ein oder mehrere Materialien umfasst, die aus der Gruppe ausgewählt sind, die aus einem Glasgewebe, einem Harzfilm, einem Fasernetzgewebe, einem Vliesstoff, einem Metallfaser-Netzgewebe und einer Metallfolie besteht.

7. Wärmeableitende Folie nach einem der Ansprüche 1 bis 6, wobei die wärmeableitende Folie (10) eine gewalzte wärmeableitende Folie ist.

8. Wärmeableitendes Element (30), das durch Verwendung der wärmeableitenden Folie nach einem der Ansprüche 1 bis 7 erhalten wird.

## Revendications

1. Feuille de dissipation de chaleur (10) ayant une configuration avec des couches de composition en silicone (14, 16) contenant une charge thermo-conductrice, chacune étant étalée sur les deux surfaces d'une couche de renforcement (12), dans laquelle une dureté de duromètre A des couches de composition en silicone est comprise dans la plage de 25 ou plus et 90 ou moins ; et
une conductivité thermique dans le sens de l'épaisseur de la feuille de dissipation de chaleur est de 2,5 W/(m·K) ou plus, **caractérisé en ce que** :
dans au moins une des couches de composition en silicone présentes sur les deux surfaces de la feuille de dissipation de chaleur, une rugosité moyenne en dix points R_{zJIS} de la surface sur le côté non collé à la couche de renforcement se situe dans la plage de 15 µm ou plus et 70 µm ou moins.

2. Feuille de dissipation de chaleur selon la revendication 1, dans laquelle la charge thermo-conductrice comprend une ou plusieurs matières choisies dans le groupe consistant en nitrure de bore, nitrure d'aluminium, oxyde d'aluminium, nitrure de silicium, oxyde de silicium et oxyde de zinc.

3. Feuille de dissipation de chaleur selon la revendication 2, dans laquelle le nitrure de bore est un nitrure de bore hexagonal.

4. Feuille de dissipation de chaleur selon la revendication 3, dans laquelle le nitrure de bore est sous la forme d'un agrégat dans lequel des particules primaires présentant des écailles de nitrure de bore ne sont pas orientées mais sont regroupées.

5. Feuille de dissipation de chaleur selon une quelconque des revendications 1 à 4, dans laquelle les couches de composition en silicone (14, 16) contiennent la charge thermo-conductrice dans la plage de 20 parties en masse ou plus et 1 500 parties en masse ou moins par rapport à un composant en silicone dans une quantité totale de 100 parties en masse.

6. Feuille de dissipation de chaleur selon une quelconque des revendications 1 à 5, dans laquelle la couche de renforcement (12) comprend une ou plusieurs matières choisies dans le groupe consistant en un tissu de verre, un film en résine, un tissu à maille en fibre, un tissu non-tissé, un tissu à maille en fibre métallique et une feuille de métal.

7. Feuille de dissipation de chaleur selon une quelconque des revendications 1 à 6, dans laquelle la feuille de dissipation de chaleur (10) est une feuille de dissipation de chaleur roulée.

8. Élément de dissipation de chaleur (30) obtenu en utilisant la feuille de dissipation de chaleur selon une quelconque des revendications 1 à 7.
